(19) Europäisches Patentamt / European Patent Office / Office européen des brevets

(11) **EP 2 439 845 B1**

(12) **EUROPEAN PATENT SPECIFICATION**

(45) Date of publication and mention
of the grant of the patent:
**23.04.2014 Bulletin 2014/17**

(51) Int Cl.:
*H03H 7/01* *(2006.01)*    *H03H 1/00* *(2006.01)*

(21) Application number: **11168988.1**

(22) Date of filing: **07.06.2011**

(54) **Common mode noise suppression circuit**

Schaltung zur Unterdrückung des Gleichtaktrauschens

Circuit de suppression du bruit en mode commun

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.07.2010 TW 099125272**

(43) Date of publication of application:
**11.04.2012 Bulletin 2012/15**

(73) Proprietor: **National Taiwan University**
**Taipei 10617 (TW)**

(72) Inventors:
 • **Wu, Tzong-Lin**
  **Taipei 10617 (TW)**
 • **Tsai, Chung-Hao**
  **Taipei 10617 (TW)**
 • **Ao Ieong, Iat In**
  **Taipei 10617 (TW)**

(74) Representative: **Baldwin, Mark**
  **Firebird IP**
  **40 Bowling Green Lane**
  **London EC1R 0NE (GB)**

(56) References cited:
**WO-A1-02/084679    US-A1- 2006 220 772**

 • **CHUNG-HAO TSAI ET AL: "A metamaterial-typed differential transmission line with broadband common-mode suppresssion", ELECTROMAGNETIC COMPATIBILITY - EMC EUROPE, 2009 INTERNATIONAL SYMPOSIUM ON, IEEE, PISCATAWAY, NJ, USA, 11 June 2009 (2009-06-11), pages 1-4, XP031499433, ISBN: 978-1-4244-4107-5**
 • **CHUNG-HAO TSAI ET AL: "A Broadband and Miniaturized Common-Mode Filter for Gigahertz Differential Signals Based on Negative-Permittivity Metamaterials", IEEE TRANSACTIONS ON MICROWAVE THEORY AND TECHNIQUES, IEEE SERVICE CENTER, PISCATAWAY, NJ, US, vol. 58, no. 1, 1 January 2010 (2010-01-01), pages 195-202, XP011286308, ISSN: 0018-9480, DOI: 10.1109/TMTT. 2009.2036413**
 • **GUANG-HWA SHIUE ET AL: "New wideband common-mode noise filter using quarter-wavelength resonator for high-speed differential signals", ELECTRICAL PERFORMANCE OF ELECTRONIC PACKAGING AND SYSTEMS (EPEPS), 2010 IEEE 19TH CONFERENCE ON, IEEE, PISCATAWAY, NJ, USA, 25 October 2010 (2010-10-25), pages 257-260, XP031806403, ISBN: 978-1-4244-6865-2**

**Description**

1. Field of the Invention

This invention relates to common mode noise filters, and more particularly, to a common mode noise suppression circuit applicable to perform broadband suppression for a common mode noise within frequency scope of several GHzs.

2. Description of Related Art

Since the electromagnetic environments in an electronic systems have become more and more complex, electromagnetic interference (EMI) phenomena our much worse and have become an obvious obstacle affecting regular operation of such systems. Since the rapid development of high speed digital circuits, data rate transmission is constantly increasing and researchers are driven to pay attention to noise suppression and crosstalk between digital systems. Ideally, a differential signal may maintain well the original signal aspect and maintain low electromagnetic radiation or electromagnetic interference. However, in an actual circuit, unbalanced delay and amplitude, or unbalanced design of input/output register or package layout may cause the differential signal to generate different rising/falling edge times such that unwanted common mode noise attaches to the differential signal. With respect to high speed data transmission interfaces, for instance, Serial ATA, PCI-E, OC-192, Gigabit Ethernet, etc., a cable always needs to transmit the differential signals between different electronic devices. A common mode noise may be coupled to an input/output cable and be formed to be an excitation source such that the input/output cable becomes an EMI antenna. Hence, in order to solve electromagnetic interference problems of the input/output cable, common mode noise on a differential signal route should be suppressed so as not to affect quality of the differential signal.

Some methods for suppressing common mode noise of differential signals are provided, wherein a common mode choke is the most typical one. The common mode choke consists of two independent coils with the same amount of wire loops winding the same magnet, wherein its structure equals a winding or feed through core coil, and it may generate high conductive impedance for common mode noise and generate impedance approaching to zero for differential signal via high magnetic conductivity needle by summation and subtraction of self inductance and mutual inductance. However, the common mode choke works only with MHz scope, the common mode choke is not easily designed to be applied above high frequency section of GHz because of the frequency characteristic and parasitics of ferromagnetic material, and the manufacturing process and complex structure of the common mode choke are not suitable to modern miniaturized circuits. Furthermore, there provides a small common mode suppression filter which could work within MHz scope according to magnetic flux elimination principle and adopts Low Temperature Co-fired Ceramic (LTCC) technology. Additionally, there also provides some common mode suppression filters using pattern ground structure to eliminate common mode noise, wherein it may have broadband common mode suppression effect within GHz scope and have low cost. However, dimension of the pattern ground structure is half or quarter of wavelength of transmission signal, it would occupy large ground area of the circuit board such that area of made common mode filter fails to be reduced.

Therefore, it is imperative to provide a common mode noise suppression circuit which may solve various disadvantage of the prior art for improving shortcomings of the prior art having too high area and bad operation performance at high frequency.

The paper entitled 'A Metamaterial Typed Differential Transmission Line with Broadband Common-Mode Suppression', Electromagnetic Compatibility (EMC Europe, 2009 International symposium on, IEEE, Piscataway, NJ, USA, 11 June 2009, pages 1-4, XP031499433, ISBN: 978-1-424 for-4107-5) discloses a common mode noise suppression circuit applicable to suppress common mode noise when transmitting a differential signal, the circuit comprising a ground layer electrically connected to a ground potential, a single layer reference potential structure, a differential transmission structure having a pair of transmission conductors disposed to form an electromagnetic coupling with the reference potential structure and a ground structure electrically connected to the reference potential structure and the ground layer performing an inductance-capacitance resonant structure together with the electromagnetic coupling formed by the reference potential structure and the differential transmission structure, and an inductance formed by the ground structure itself so as to suppress a common mode signal that one or more specific frequencies.

SUMMARY OF THE INVENTION

In view of the above-mentioned problems of the prior art, it is a primary objective of the invention to provide a common mode noise suppression mechanism applicable to high speed or high frequency digital differential signals.

The invention provides a common mode noise suppression circuit applicable to suppress a common mode noise when transmitting a differential signal as specified in claim 1.

BRIEF DESCRIPTION OF DRAWINGS

FIG. 1 illustrates the architecture of an example of a common mode noise suppression circuit;

FIG. 2A is a schematic stereo diagram of an example of a common mode noise suppression circuit;

FIG. 2B is a top plan view of the common mode noise suppression circuit of FIG 2A;

FIG. 2C is a side view of the common mode noise suppression circuit of FIG 2A;

FIG. 3A is a schematic diagram of a double-zero even mode equivalent circuit of the common mode noise suppression circuit shown in FIG 2A;

FIG 3B is a schematic diagram of an even mode equivalent circuit of an inductance-capacitance resonant structure operated at a specific frequency under the condition when a serial resonance occurrs;

FIG. 3C is a schematic diagram of the even mode equivalent circuit of the inductance-capacitance resonant structure operated at a specific frequency under the condition when a parallel resonance occurrs;

FIG. 4A is a schematic diagram of two resonant zeros formed by the common mode noise suppression circuit;

FIG. 4B is a schematic diagram of extra zeros generated by a transmission line structure at a higher specific frequency formed by the common mode noise suppression circuit based on transmission line effect or electromagnetic coupling effect combining inductance effect of the ground structure;

FIG. 5A is a schematic stereo diagram of the common mode noise suppression circuit;

FIG. 5B is a side view diagram of the common mode noise suppression circuit;

FIG. 6 illustrates an equivalent lumped circuit of the common mode noise suppression circuit having one degree shown in FIG. 5A;

FIG. 7A illustrates an odd mode equivalent circuit of the equivalent lumped circuit shown in FIG. 6;

FIG. 7B illustrates an even mode equivalent circuit of the equivalent lumped circuit shown in FIG. 6;

FIG. 8 illustrates an equivalent lumped circuit of the common mode noise suppression circuit having five degrees;

FIG. 9A illustrates an odd mode equivalent circuit of the equivalent lumped circuit shown in FIG. 8;

FIG. 9B illustrates an even mode equivalent circuit of the equivalent lumped circuit shown in FIG. 8;

FIG. 10 is a cross-sectional view of the common mode noise suppression circuit in accordance with an embodiment of the invention;

FIG. 11 illustrates a differential transmission structure of the common mode noise suppression circuit;

FIG 12 illustrates a differential transmission structure of the common mode noise suppression circuit;

FIG. 13 illustrates a reference potential structure of the common mode noise suppression circuit in accordance with an embodiment of the invention;

FIG 14 illustrates a ground structure of the common mode noise suppression circuit; and

FIG. 15 illustrates a ground structure of the common mode noise suppression circuit.

DETAILED DESCRIPTION

The following examples and embodiments are provided simply to illustrate the invention. Numerous modifications and variations can be devised without departing from the scope of the invention as defined by the claims.

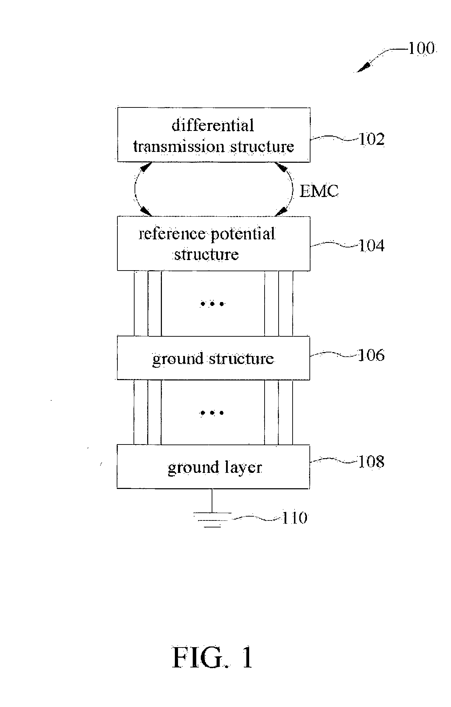

FIG. 1 is a schematic diagram of an example of a common mode noise suppression circuit 100. As illustrated, the common mode noise suppression circuit 100 comprises a differential transmission structure 102, a reference potential structure 104, a ground structure 106 and a ground layer 108.

Electromagnetic coupling (EMC) is formed between the differential transmission structure 102 and the reference potential structure 104 to generate coupling capacitance and coupling inductance between both while generating mutual induction and mutual capacitance between transmission conductors of the differential transmission structure 102. For example, the differential transmission structure 102 may comprise a pair of parallel and/or symmetric transmission conductors or differential transmission lines, wherein the two transmission conductors or transmission lines form an electromagnetic coupling with respect to the reference potential structure 104. Hence there is coupling capacitance and coupling inductance between the reference potential structure 104 and the two transmission conductors or the transmission lines while these transmission conductors or the transmission lines generate mutual induction and mutual capacitance between both.

The reference potential structure 104 may comprise a main body in any shape formed from conductors. For instance, the reference potential structure 104 may be a surface that is flat, arc-shaped, corrugated or irregular able to form an electromagnetic coupling with respect to the differential transmission structure 102.

The ground structure 106 is electrically connected to the reference potential structure 104 and the ground layer 108 respectively and forms inductance between the reference potential structure 104 and the ground layer 108. Additionally, inductance formed by the ground structure 106 may form an inductance-capacitance resonant structure together with the coupling capacitance and the coupling inductance generated by the electromagnetic coupling between the differential transmission structure 102 and the reference potential structure 104 previously described.

The ground layer 108 is electrically connected to a ground potential 110.

A dielectric material or a ferromagnetic/ferrimagnetic material layer is further disposed between the reference potential structure 104 and the differential transmission structure 102 to regulate values of the coupling capacitance or the coupling inductance. A ferromagnetic/ferrimagnetic material layer is disposed between the reference potential structure 104 and the ground layer 108 to regulate inductance values formed by the ground structure 106.

When the inductance-capacitance resonant structure of the common mode noise suppression circuit 100 is operated at a first specific frequency, a serial resonance occurs and a low impedance path for a common mode signal is formed thereby (Zero), so the common mode signal can be guided to the ground potential 110. Alternatively, when the inductance-capacitance resonant structure is operated at a second specific frequency, a parallel resonance occurs and a high impedance path for the common mode signal is formed thereby, so the common mode signal can be reflected to an original route. This response is very similar to the Zero so as to achieve common mode signal suppression effect.

It should be explained that the first specific frequency and the second specific frequency may be the same or different according to the dimensions and characteristics of each component of the common mode noise suppression circuit 100.

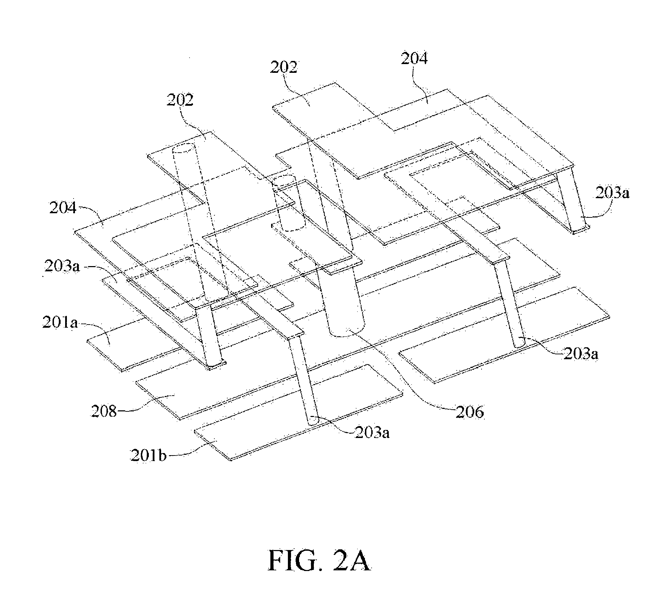

Referring to FIGs. 2A-2C, an example of a common mode noise suppression circuit comprises a differential transmission conductor 202, a reference potential structure 204, a ground structure 206 and a ground layer 208. These differential transmission conductors 202 may be connected to a differential signal input terminal 201a and a differential signal output terminal 201b via conductive vias 203a, 203b like a blind via structure.

The reference potential structure 204 is formed from conductors and, although not limited to this, in the example illustrated by FIG 2A is a plate structure.

The differential transmission conductors 202 are disposed to be partially parallel to the reference potential structure 204, symmetric to each other, used for transmitting differential signals, spaced at the same distance from the reference potential structure 204, and respectively form an electromagnetic coupling with the reference potential structure 204 (It will be explained later). When transmitting differential signals, the two transmission conductors 202 generate electromagnetic coupling respectively with the reference potential structure 204 and mutual induction and mutual capacitance with each other thereby forming a transmission line characteristic so as to transmit the differential signals under transmission condition of very low attenuation and loss.

The ground layer 208 is electrically connected to a ground potential (GND) and the ground structure 206.

The ground structure 206 is electrically connected to the reference potential structure 204 at a midline location of the two differential transmission conductors 202. Inductance formed by the ground structure 206 may form an inductance-capacitance resonant structure in cooperation with the coupling capacitance and the coupling inductance generated by the electromagnetic coupling between these differential transmission conductors 202 and the reference potential structure 204.

The values of each capacitance or inductance element in an equivalent circuit may be changed according to the demand of a designer by regulating the width of these differential transmission conductors 202, the distance between them and the width and length of the reference potential structure. The inductance-capacitance resonant structure may form a low impedance path for a common mode signal at some specific frequencies, such that the common mode signal is guided to the ground potential. Furthermore, the inductance-capacitance resonant structure may form a high impedance path for the common mode signal, such that the common mode signal is reflected to an original route thereby generating an effect similar to the zero.

As previously described, the common mode noise suppression circuit suppresses common mode noise (signals) while not affecting differential signal transmission. It should be explained that the common mode noise suppression circuit shown in FIG. 2A only illustrates an architecture in unit length, that is, this architecture may also be applicable to a combination of plural similar architectures.

In another example, the two differential transmission conductors 202 may be symmetric conductive lines or metal interconnections, a circular surface, a corrugated surface or an irregular surface. The ground structure 206 may be achieved via a more complex conductor structure in combination with a conductive via. Other modifications or implementation aspects of the previously described transmission conductor, reference potential structure and ground structure will be described in the following description.

In embodiments of the invention, the reference potential structure 204 may be a combination of a multi-layered plates.

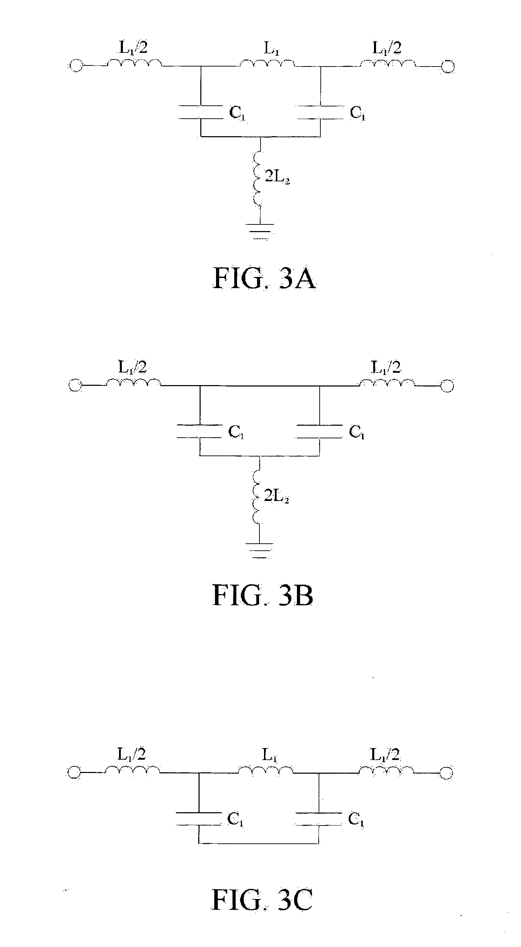

FIG. 3A is a schematic diagram of a double-zero even mode equivalent circuit of the common mode noise suppression circuit shown in FIG. 2A. As illustrated, this double-zero even mode equivalent circuit is an equivalent circuit with two degrees, wherein the inductance $L_1$ is a coupling inductance generated between the transmission conductor and the reference potential structure, the coupling capacitance $C_1$ is a coupling capacitance generated between the transmission conductor and the reference potential structure, and the inductance $2L_2$ is an even mode equivalent inductance between the reference potential structure and the ground layer generated by the ground structure.

The inductance $2L_2$ is a lower circuit while others, except the inductance $2L_2$, is an upper circuit. The upper circuit and lower circuit are used for conveniently explaining relative locations of the technical features and not a restriction of implementation aspects of the circuits. In order to find a zero of this circuit, it may first find its transmission impedance $Z_{21}$. Since this circuit may be a cascode of the upper and the lower, there is:

$$\begin{bmatrix} V_1 \\ V_2 \end{bmatrix} = \begin{bmatrix} V_1^a + V_1^b \\ V_2^a + V_2^b \end{bmatrix} = \begin{bmatrix} Z_{11}^a + Z_{11}^b & Z_{12}^a + Z_{12}^b \\ Z_{21}^a + Z_{21}^b & Z_{22}^a + Z_{22}^b \end{bmatrix} \begin{bmatrix} i_1 \\ i_2 \end{bmatrix}$$

$$Z_{total} = Z_a + Z_b,$$

That is, its Z matrix is a summation of its upper Z matrix and Lower Z matrix. Hence, $Z_{21}$ of this circuit is a summation of $Z_{21}$ of the upper circuit and $Z_{21}$ of the lower circuit. Solving Eigen values of "$Z_{21}$"0" may find the zero of the circuit.

For the upper circuit, $Z_{21\_up} = \dfrac{1}{2j\omega C_1 - j\omega^3 L_1 C_1^2}$.

For the lower circuit, $Z_{21\_down} = 2j\omega L_2$.

Let $Z_{21} = Z_{21\_up} + Z_{21\_down} = 0$ and then obtain,

$$\omega_{z1,z2} = \sqrt{\frac{1 \pm \sqrt{1 - L_1 / 2L_2}}{L_1 C_1}} \qquad (1)$$

Generally, $L_1$ and $L_2$ may be designed so that $L_2 > L_1$ such that

$$\omega_{z1} \cong \frac{1}{\sqrt{2L_2 2C_1}}, \ \omega_{z2} \cong \frac{1}{\sqrt{L_1 C_1 / 2}} \qquad (2)$$

The following description will explain a physical mechanism of resonant zero disclosed in equation (2) in cooperation with FIG. 3B and FIG. 3C.

According to equation (2), it may realize that a first resonant zero is frequency when the inductance-capacitance resonant structure is operated under the condition when a serial resonance occurs. As illustrated in FIG. 3B, it shows that the inductance-capacitance resonant structure is operated at a first resonant zero frequency under the condition when a serial resonance occurs, and a low impedance path for a common mode signal is formed thereby, so the common mode signal can be guided to the ground structure.

Moreover, according to equation (2), it may realize that a second resonant zero is frequency when the inductance-capacitance resonant structure is operated under the condition when a parallel resonance occurs. As illustrated in FIG. 3C, it shows that the inductance-capacitance resonant structure is operated at a second resonant zero frequency under the condition when a serial resonance occurs, a high impedance path for the common mode signal is formed thereby, so the common mode signal can be reflected to the original route and thus failing to go on transmission.

It should be explained that although the common mode noise suppression circuit may be represented by equivalent circuits with higher degrees (for instance, three or five), adopting equivalent circuits having higher degrees with respect to common mode signal generates double-zero to suppress common mode signal within frequency scope considered in the present invention. Hence analyzing double-zero circuits with two degrees is quite representative in some level and may simplify analysis process.

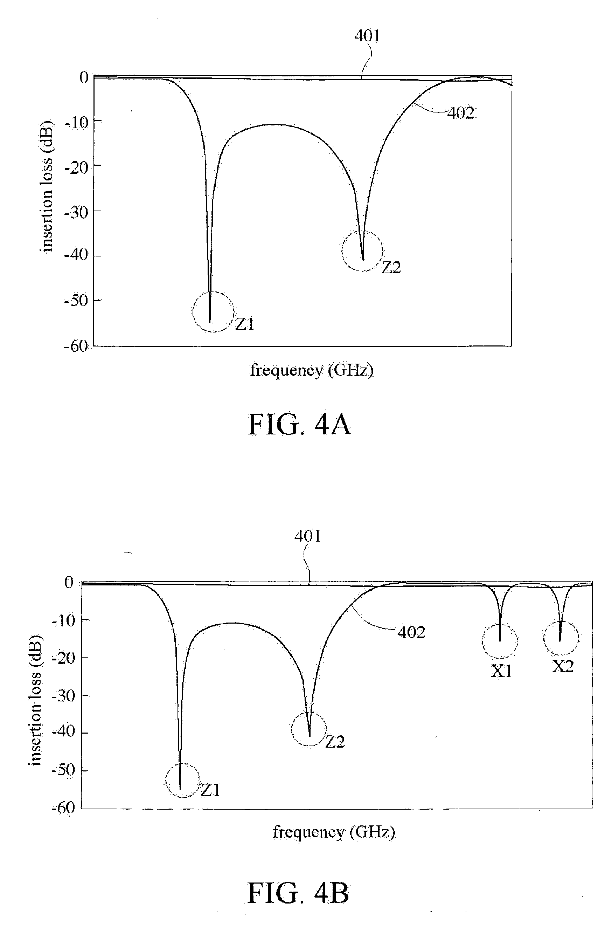

FIG. 4A is a schematic diagram showing two resonant zeros $Z_1$, $Z_2$ formed by a common mode noise suppression circuit. A curve 401 is the transmission condition of a differential mode signal at each frequency. By this, the differential mode signal is transmitted normally in the common mode noise suppression circuit and not affected or suppressed. In contrast, a curve 402 is the transmission condition of a common mode signal at each frequency and generates the previously described resonant zeros $Z_1$, $Z_2$ at specific frequency. It should be realized that the first resonant zero $Z_1$ and the second resonant zero $Z_2$ may be at the same frequency or not according to dimension and characteristic of each component of the common mode noise suppression circuit.

It should be explained that the transmission conductor having transmission line characteristic at high frequency is affected by electromagnetic coupling effect or transmission line effect combining inductance effect of the ground structure and then generates phenomenon similar to zero at specific one or plural frequencies, wherein these phenomena similar to zero may result in the zero similar to the aim of the invention, however substantially physical theorem is not the same. As for details of electromagnetic coupling effect and transmission line effect are not described herein. FIG. 4B shows a schematic diagram of zeros $X_1$, $X_2$ generated by a transmission line structure at higher specific frequency formed by the common mode noise suppression circuit based on transmission line effect or electromagnetic coupling effect combining inductance effect of the ground structure in accordance with the present invention. Compared with FIG. 4A, FIG. 4B shows for instance two additional zeros at higher frequency based on characteristic of a transmission line or a transmission conductor while there may be more than two or any quantity of similar zeros. As previously described, this kind of phenomenon similar to zero results from electromagnetic coupling effect or transmission line effect of a transmission line structure. Hence, the two extra zeros $X_1$, $X_2$ are not the same with the resonant zeros $Z_1$, $Z_2$ disclosed in the present invention.

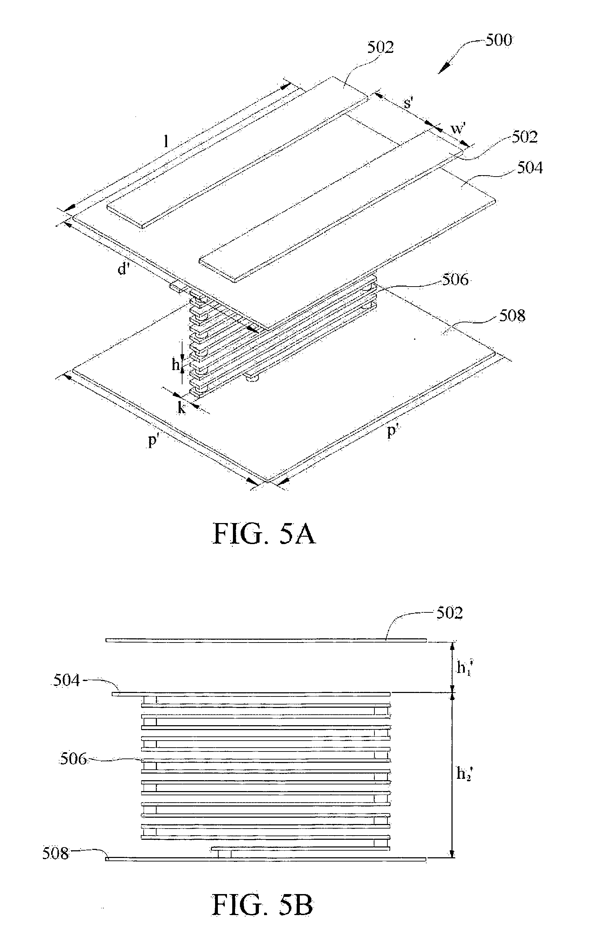

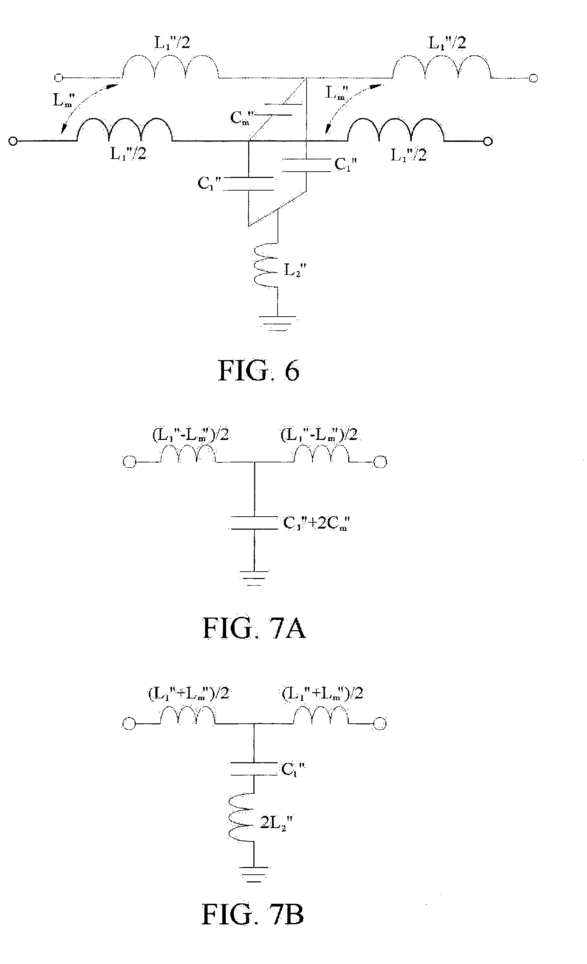

Referring to FIGs. 5A and 5B, a common mode noise suppression circuit 500 substantially consists of a pair of transmission conductors 502, a reference potential structure 504, a ground structure 506 and a ground layer 508. The designer may design a line width w' and a distance s' of these transmission conductors 502 according to transmission impedance of the system. With respect to common mode noise suppression effect of the common mode noise suppression circuit 500, the designer may further regulate each layer height h and layer width k of the ground structure 506, width d' and length l of the reference potential structure 504, height $h_1$' of the space between the transmission conductors 502 and the reference potential structure 504 and the overall height $h_2$' of the ground structure. The common mode noise suppression circuit 500 may be representative of a lumped circuit model illustrated in FIG. 6 within considered frequency scope when unit length p' of the structure (length of the ground layer 508) is less than operating wavelength of a signal.

A distributed equivalent circuit shown in FIG. 6 may be expressed as odd and an even mode distributed equivalent circuits respectively shown in FIGs. 7A and 7B. In FIG. 7A, the odd mode equivalent circuit comprising a two inductance in series and a parallel (bypass) capacitance forms a typical right-handed transmission line equivalent circuit. In the architecture of FIG. 7A, the differential mode signal may be transmitted well before achieving a cut-off frequency $\omega_c$ (as illustrated in equation (3)).

$$\omega_c \cong 2 / \sqrt{(L_1'' - L_m'')(C_1'' + 2C_m'')} \qquad (3)$$

In FIG. 7B, the even mode equivalent circuit consists of serial LC resonators. Since a serial resonance occurs when the inductance-capacitance resonator is operated at a resonance frequency $\omega_0$, common mode noise closing to the resonance frequency $\omega_0$ may be suppressed.

$$\omega_0 = 1 / \sqrt{2 L_2'' C_1''} \qquad (4)$$

It may be easily understood that the designer may control the desired scope of the common mode noise suppression frequency by regulating or selecting appropriate inductance $L_2''$.

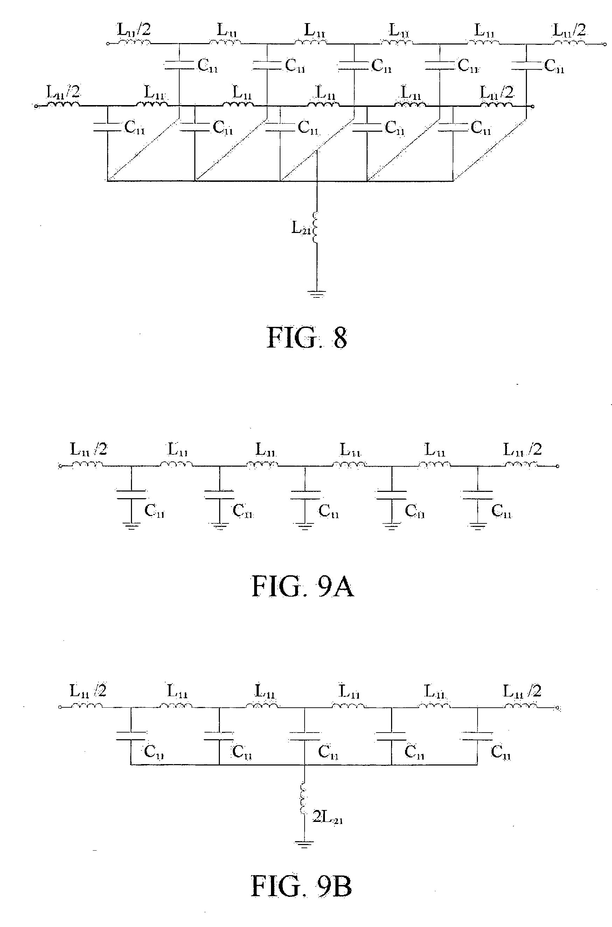

In the common mode noise suppression circuit, each transmission conductor and the reference potential structure may be approximated to be a uniform transmission line and it expresses electromagnetic coupling effect of each transmission conductor and the reference potential structure in the common mode noise suppression circuit as a ladder network form based on plural sections of transmission line model (T-model) (for instance, represented by five T-models consisting of inductance $L_{11}$ and capacitance $C_{11}$). FIG. 8 illustrates an equivalent lumped circuit having five degrees of the common mode noise suppression circuit. For the differential mode signal, the equivalent circuit shown in FIG. 8 may further be expressed as the odd mode equivalent circuit shown in FIG. 9A. As illustrated in FIG. 9A, with respect to the differential mode signal, transmission line structure consisting of inductance $L_{11}$ and capacitance $C_{11}$ supplies transmission characteristic of low attenuation and low loss for the differential mode signal such that the differential mode signal transmission is not affected. FIG. 9B illustrates the even mode equivalent circuit of the equivalent lumped circuit shown in FIG. 8. With respect to the common mode signal, the resonator structure consisting of inductance $L_{11}$, $L_{21}$ and capacitance $C_{11}$ generates serial resonance at a first specific frequency, and then a low impedance path for the common mode signal is formed, such that the common mode signal is guided to the ground potential and thus forming a first zero. Besides, the resonator structure generates parallel resonance at a second specific frequency, and then a high impedance path for the common mode signal is formed, such that the common mode signal is reflected to the original route and thus failing to be transmitted to form a second zero. Hence, the equivalent lumped circuit shown in FIG. 8 suppresses the common mode signal while keeping unaffected transmission of the differential mode signal. It should be appreciated that the first specific frequency and the second specific frequency may be the same or not.

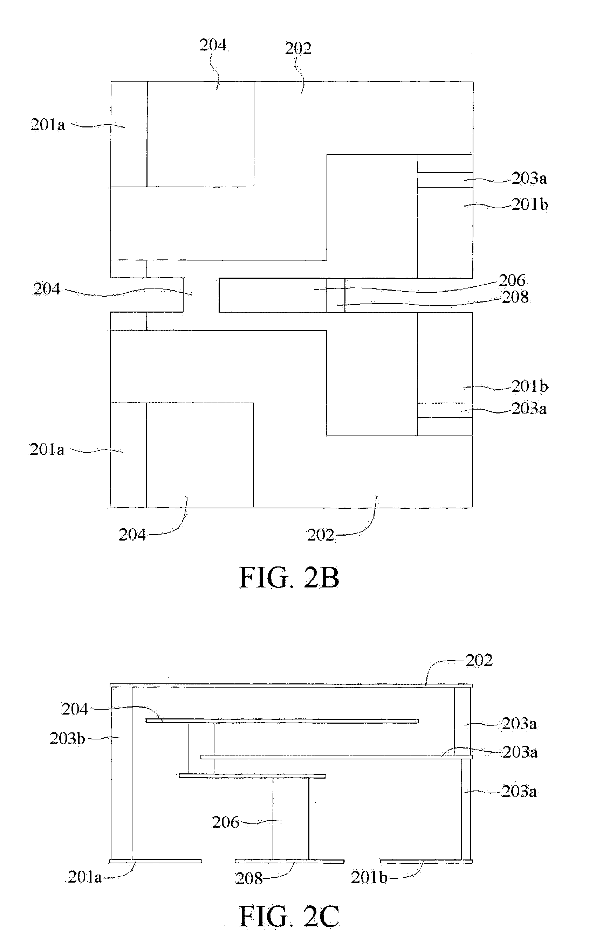

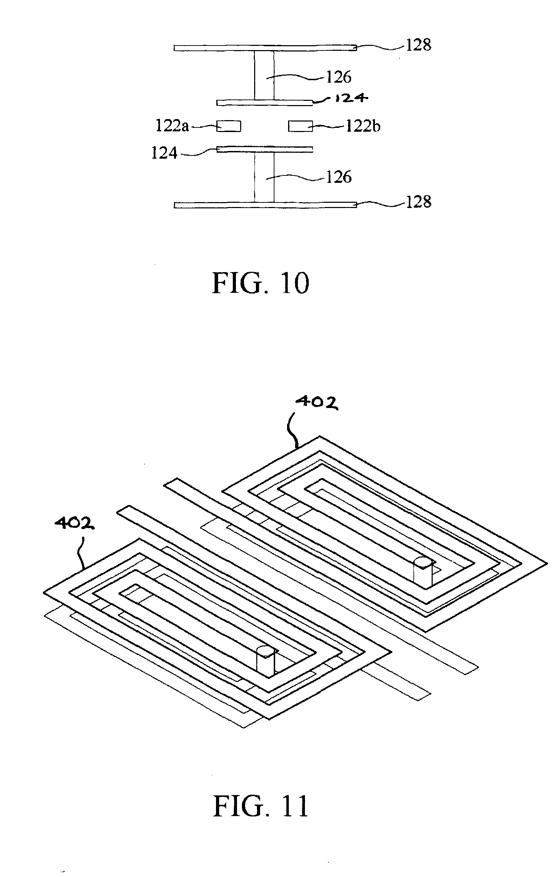

FIG. 10 is a cross-sectional view of a common mode noise suppression circuit in accordance with an embodiment of the invention. As illustrated, there are symmetric reference potential structures 124 disposed on two sides of the transmission conductors 122a, 122b, wherein the reference potential structures are respectively electrically connected to the ground layer 128 via the ground structure 126. By this, the common mode noise suppression circuit of the invention may be modified and combined based on structures shown in FIG. 2. It may combine the plural unit length structures in various relative locations according a designer's demand to provide the desired common mode noise suppression effect.

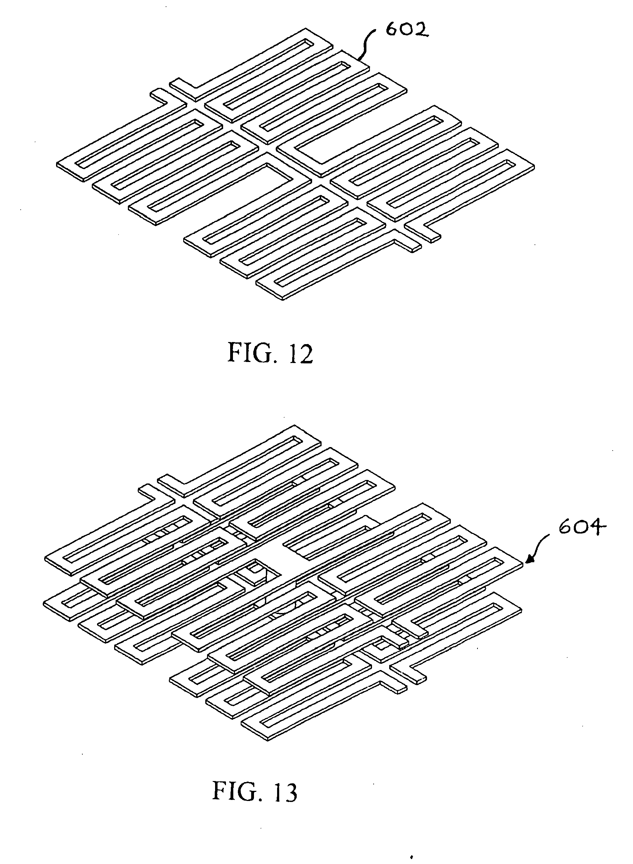

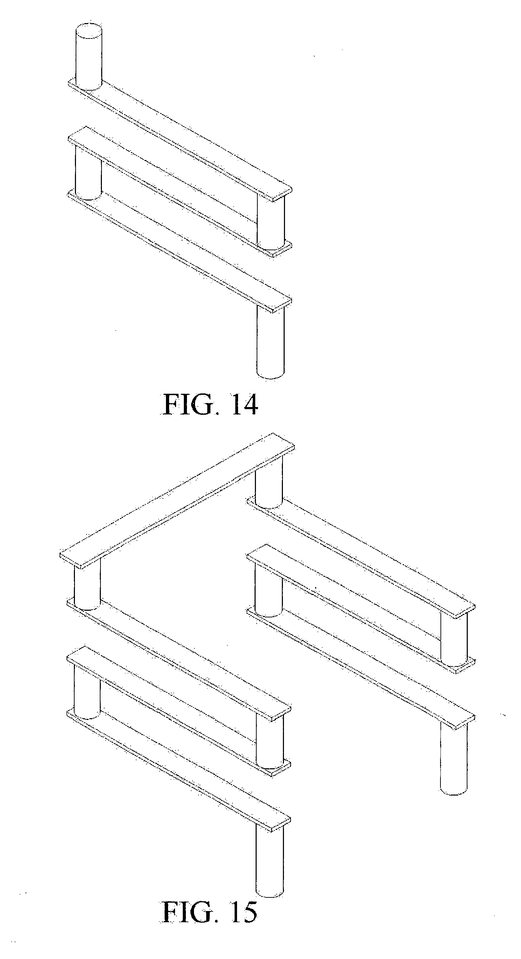

Examples FIGs. 11 and 12 illustrate possible examples of a differential transmission structure 402, 602. Additionally, FIG. 13 illustrates a possible embodiment of a reference potential structure 604. Furthermore, FIGs. 14 and 15 illustrate examples of a ground structure.

The common mode noise suppression circuits described above suppress high frequency common mode noise without affecting quality of differential signals..They may provide miniaturization of a common mode noise filter circuit and may be realized on a circuit board so as to provide a common mode noise suppression solution having performance superiority and cost benefit thereby preventing problems of too low operating frequency and too high cost or too complex manufacturing process in the prior art.

## Claims

1.  A common mode noise suppression circuit applicable to suppress a common mode noise when transmitting a differential signal, said suppression circuit comprising a ground layer (128) electrically connected to a ground potential and **characterised by**:

    a reference potential structure (124; 604) comprising a plurality of conductor layers that define a multi-layered conductor structure ;
    a differential transmission structure (122a, 122b) disposed to form an electromagnetic coupling with the reference potential structure, wherein the differential transmission structure has a pair of transmission conductors for transmitting the differential signal, and the two transmission conductors respectively form the electromagnetic coupling with relation to the reference potential structure so as to form a transmission line characteristic to prevent differential mode transmission from being affected when transmitting the differential signal; and
    a ground structure (126) electrically connected to the reference potential structure and the ground layer for forming an inductance-capacitance resonant structure together with the electromagnetic coupling formed by the reference potential structure and the differential transmission structure, and an inductance formed by the ground structure itself, so as to suppress a common mode signal at one or more specific frequencies.

2.  The common mode noise suppression circuit of claim 1, wherein each layer of the multi-layered conductor (604) comprises a meandering conductor element.

3.  The common mode noise suppression circuit of claim 1, wherein each layer of the multi-layered conductor structure is connected by a conductive via.

4.  The common mode noise suppression circuit of claim 1, wherein the multi-layered conductor structure comprises two layers (124) arranged such that said differential transmission structure (122a, 122b) is disposed between said two layers, said two layers being disposed symmetrically with respect to said differential transmission structure.

5.  The common mode noise suppression circuit of claim 1, wherein the two transmission conductors are disposed to be parallel and/or symmetric to each other.

6.  The common mode noise suppression circuit of claim 1, wherein an equivalent lumped circuit is formed by the electromagnetic coupling generated between the reference potential structure (124; 604) and the differential transmission structure (122a, 122b) and the inductance generated by the ground structure (126), the equivalent lumped circuit comprises two groups of a plurality of sections of transmission line models, each section of the transmission line model in each group is formed by two series coupling inductances and a parallel coupling capacitance and each of the coupling capacitances is connected together and grounded via the inductance.

7. The common mode noise suppression circuit of claim 6, wherein the equivalent lumped circuit is expressed as an odd mode equivalent circuit, the odd mode equivalent circuit comprises a plurality of sections of transmission line models, each section of the transmission line model is formed by the corresponding series coupling inductances and the corresponding parallel coupling capacitance and each of the coupling capacitances is grounded directly.

8. The common mode noise suppression circuit of claim 6, wherein the equivalent lumped circuit is expressed as an even mode equivalent circuit, the even mode equivalent circuit comprises a plurality of sections of transmission line models , each section of the transmission line model is formed by the corresponding series coupling inductances and the corresponding parallel coupling capacitance and each of the coupling capacitances is connected together and grounded via the inductance.

**Patentansprüche**

1. Gleichtaktrauschunterdrückungsschaltung, die dazu anwendbar ist, ein Gleichtaktrauschen zu unterdrücken, wenn ein Differenzsignal übertragen wird, wobei die Unterdrückungsschaltung eine Masselage (128) umfasst, die mit einem Massepotential elektrisch verbunden ist und durch Folgendes gekennzeichnet ist:

eine Bezugspotentialstruktur (124; 604), die mehrere Leiterlagen umfasst, die eine mehrlagige Leiterstruktur definieren;
eine differentielle Übertragungsstruktur (122a, 122b), die angeordnet ist, um eine elektromagnetische Kopplung mit der Bezugspotentialstruktur zu bilden, wobei die differentielle Übertragungsstruktur ein Paar Übertragungsleiter zum Übertragen des Differenzsignals aufweist und die zwei Übertragungsleiter jeweils die elektromagnetische Kopplung in Bezug auf die Bezugspotentialstruktur bilden, um ein Übertragungsleitungskennlinie zu bilden, um zu verhindern, dass eine Differenzmodusübertragung beeinträchtigt wird, wenn das Differenzsignal übertragen wird; und
eine Massestruktur (126), die mit der Bezugspotentialstruktur und der Masselage elektrisch verbunden ist, um eine Induktanz-Kapazität-Resonanzstruktur zusammen mit der elektromagnetischen Kopplung, die von der Bezugspotentialstruktur und der differentiellen Übertragungsstruktur gebildet wird, und eine Induktanz, die von der Massestruktur selbst gebildet wird, zu bilden, um ein Gleichtaktsignal mit einer oder mehreren spezifischen Frequenzen zu unterdrücken.

2. Gleichtaktrauschunterdrückungsschaltung nach Anspruch 1, wobei jede Lage des mehrlagigen Leiters (604) ein mäandrierendes Leiterelement umfasst.

3. Gleichtaktrauschunterdrückungsschaltung nach Anspruch 1, wobei jede Lage der mehrlagigen Leiterstruktur mit einer leitfähigen Durchkontaktierung verbunden ist.

4. Gleichtaktrauschunterdrückungsschaltung nach Anspruch 1, wobei die mehrlagige Leiterstruktur zwei Lagen (124) umfasst, die derart eingerichtet sind, dass die differentielle Übertragungsstruktur (122a, 122b) zwischen den zwei Lagen angeordnet ist, wobei die zwei Lagen in Bezug auf die differentielle Übertragungsstruktur symmetrisch angeordnet ist.

5. Gleichtaktrauschunterdrückungsschaltung nach Anspruch 1, wobei die zwei Übertragungsleiter so angeordnet sind, dass sie zueinander parallel und/oder symmetrisch sind.

6. Gleichtaktrauschunterdrückungsschaltung nach Anspruch 1, wobei eine äquivalente konzentrierte Schaltung von der elektromagnetischen Kopplung, die zwischen der Bezugspotentialstruktur (124; 604) und der differentiellen Übertragungsstruktur (122a, 122b) erzeugt wird, und der Induktanz, die von der Massestruktur (126) erzeugt wird, gebildet wird, wobei die äquivalente konzentrierte Schaltung zwei Gruppen mehrerer Abschnitte von Übertragungsleitungsmodellen umfasst, wobei jeder Abschnitt des Übertragungsleitungsmodells in jeder Gruppe von zwei seriellen Koppelinduktanzen und einer parallelen Koppelkapazität gebildet wird und jede der Koppelkapazitäten miteinander verbunden und mittels der Induktanz geerdet ist.

**7.** Gleichtaktrauschunterdrückungsschaltung nach Anspruch 6, wobei die äquivalente konzentrierte Schaltung als eine äquivalente Gegentaktschaltung dargestellt ist, wobei die äquivalente Gegentaktschaltung mehrere Abschnitte von Übertragungsleitungsmodellen umfasst, wobei jeder Abschnitt des Übertragungsleitungsmodells von den entsprechenden seriellen Koppelinduktanzen und der entsprechenden parallelen Koppelkapazität gebildet wird und jede der Koppelkapazitäten direkt geerdet ist.

**8.** Gleichtaktrauschunterdrückungsschaltung nach Anspruch 6, wobei die äquivalente konzentrierte Schaltung als eine äquivalente Gleichtaktschaltung dargestellt ist, wobei die äquivalente Gleichtaktschaltung mehrere Abschnitte von Übertragungsleitungsmodellen umfasst, wobei jeder Abschnitt des Übertragungsleitungsmodells von den entsprechenden seriellen Koppelinduktanzen und der entsprechenden parallelen Koppelkapazität gebildet wird und jede der Koppelkapazitäten miteinander verbunden und mittels der Induktanz geerdet ist.

## Revendications

**1.** Circuit de suppression de bruit de mode commun applicable à des fins de suppression d'un bruit de mode commun lors de la transmission d'un signal différentiel, ledit circuit de suppression comportant une couche de masse (128) connectée de manière électrique au niveau d'un potentiel de masse et **caractérisé par** :

une structure de potentiel de référence (124 ; 604) comportant une pluralité de couches conductrices qui définissent une structure conductrice à plusieurs couches ;
une structure de transmission différentielle (122a, 122b) disposée afin de former un couplage électromagnétique avec la structure de potentiel de référence, dans lequel la structure de transmission différentielle a une paire de conducteurs de transmission permettant de transmettre le signal différentiel, et les deux conducteurs de transmission forment respectivement le couplage électromagnétique par rapport à la structure de potentiel de référence de telle manière à former une caractéristique de ligne de transmission afin d'empêcher la transmission de mode différentiel d'être affectée lors de la transmission du signal différentiel ; et
une structure de masse (126) connectée de manière électrique au niveau de la structure de potentiel de référence et de la couche de masse afin de former une structure résonante de type inductance-capacité avec le couplage électromagnétique que forment la structure de potentiel de référence et la structure de transmission différentielle, et une inductance formée par la structure de masse elle-même, de manière à supprimer un signal de mode commun à une ou plusieurs fréquences spécifiques.

**2.** Circuit de suppression de bruit de mode commun selon la revendication 1, dans lequel chaque couche du conducteur à plusieurs couches (604) comporte un élément conducteur allant en méandres.

**3.** Circuit de suppression de bruit de mode commun selon la revendication 1, dans lequel chaque couche de la structure conductrice à plusieurs couches est connectée par le biais d'un trou d'interconnexion conducteur.

**4.** Circuit de suppression de bruit de mode commun selon la revendication 1, dans lequel la structure conductrice à plusieurs couches comporte deux couches (124) agencées de telle sorte que ladite structure de transmission différentielle (122a, 122b) est disposée entre lesdites deux couches, lesdites deux couches étant disposées de manière symétrique par rapport à ladite structure de transmission différentielle.

**5.** Circuit de suppression de bruit de mode commun selon la revendication 1, dans lequel les deux conducteurs de transmission sont disposés pour être parallèles et/ou symétriques l'un par rapport à l'autre.

**6.** Circuit de suppression de bruit de mode commun selon la revendication 1, dans lequel un circuit à constantes localisées équivalent est formé par le couplage électromagnétique généré entre la structure de potentiel de référence (124 ; 604) et la structure de transmission différentielle (122a, 122b) et l'inductance générée par la structure de masse (126), le circuit à constantes localisées équivalent comporte deux groupes d'une pluralité de sections de modèles de ligne de transmission, chaque section de modèle de ligne de transmission dans chaque groupe est formée au moyen de deux inductances à couplage en série et d'une inductance à couplage en parallèle et chacune des capacités de couplage est connectée ensemble et mise à la masse par le biais de l'inductance.

**7.** Circuit de suppression de bruit de mode commun selon la revendication 6, dans lequel le circuit à constantes localisées équivalent est exprimé sous la forme d'un circuit équivalent de mode impair, le circuit équivalent de mode impair comporte une pluralité de sections de modèles de ligne de transmission, chaque section du modèle de ligne de transmission est formée au moyen des inductances à couplage en série correspondantes et de la capacité à couplage parallèle correspondante et chacune des capacités de couplage est directement mise à la masse.

8. Circuit de suppression de bruit de mode commun selon la revendication 6, dans lequel le circuit à constantes localisées équivalent est exprimé sous la forme d'un circuit équivalent de mode pair, le circuit équivalent de mode pair comporte une pluralité de sections de modèles de ligne de transmission, chaque section du modèle de ligne de transmission est formée au moyen des inductances à couplage en série correspondantes et de la capacité à couplage parallèle correspondante et chacune des capacités de couplage est connectée ensemble et mise à la masse par le biais de l'inductance.

—100

```
┌─────────────────────────┐
│      differential       │ ──── 102
│ transmission structure  │
└─────────────────────────┘
         ⤡    ⤢  ) EMC
┌─────────────────────────┐
│   reference potential   │ ──── 104
│       structure         │
└─────────────────────────┘
         ‖      ‖
            • • •
┌─────────────────────────┐
│    ground structure     │ ──── 106
└─────────────────────────┘
         ‖      ‖
            • • •
┌─────────────────────────┐
│      ground layer       │ ──── 108
└─────────────────────────┘
            ⏚ ──── 110
```

# FIG. 1

FIG. 2A

204  202

201a —

203a
201b

204 —
206
208

201b
203a

201a —

204  202

## FIG. 2B

202

204
203b —
203a
203a
203a

206

201a —  208 —  201b —

## FIG. 2C

$L_1/2$      $L_1$      $L_1/2$

$C_1$      $C_1$

$2L_2$

## FIG. 3A

$L_1/2$                $L_1/2$

$C_1$      $C_1$

$2L_2$

## FIG. 3B

$L_1/2$      $L_1$      $L_1/2$

$C_1$      $C_1$

## FIG. 3C

FIG. 4A

FIG. 4B

FIG. 5A

FIG. 5B

FIG. 6

FIG. 7A

FIG. 7B

FIG. 8

FIG. 9A

FIG. 9B

128
126
124
122a 122b
124
126
128

## FIG. 10

402
402

## FIG. 11

602

FIG. 12

604

FIG. 13

FIG. 14

FIG. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• A Metamaterial Typed Differential Transmission Line with Broadband Common-Mode Suppression. *Electromagnetic Compatibility (EMC Europe, 2009 International symposium on, IEEE, Piscataway, NJ, USA,* 11 June 2009, ISBN 978-1-424, 1-4